# FASCICULE DE BREVET EUROPEEN

(11) **EP 2 233 435 B1**
(45) Date de publication et mention de la délivrance du brevet: **25.10.2017**
(21) Numéro de dépôt: 10157351.7
(22) Date de dépôt: 23.03.2010
(51) Int. Cl.: C01B 32/184, C01B 32/186, B82Y 30/00, B82Y 40/00, C23C 16/26, H01L 21/02, C23C 16/56

(54) **Procede d'elaboration de graphene**
Herstellungsverfahren von Graphen
Method for producing graphene

(30) Priorité: 25.03.2009 FR 0951936
(43) Date de publication de la demande: 29.09.2010
(73) Titulaire: Commissariat à l'Énergie Atomique et aux Énergies Alternatives, 75015 Paris (FR)
(72) Inventeur: Zenasni, Aziz, 38610 Gieres (FR)
(74) Mandataire: Ilgart, Jean-Christophe

(56) Documents cités:
- J. CORAUX, A. N'DIAYE, M. ENGLER, C. BUSSE, D. WALL, N. BUCKANIE, F-J. MEYER ZU HERINGDORF, R. VAN GASTEL, B. POELSEMA, T. MICHELY: "Growth of graphene on Ir(111)" NEW JOURNAL OF PHYSICS, vol. 11, 4 février 2009 (2009-02-04), pages 023006-023027, XP002563349
- SCILLETTA C ET AL: "Influence of substrate temperature and atmosphere on nano-graphene formation and texturing of pulsed Nd:YAG laser-deposited carbon films" APPLIED SURFACE SCIENCE, ELSEVIER, AMSTERDAM, NL, vol. 252, no. 13, 30 avril 2006 (2006-04-30), pages 4877-4881, XP024893366 ISSN: 0169-4332 [extrait le 2006-04-30]
- C. TANG, L. MENG, H. XIAO, J. ZHONG: "Growth of Graphene Structure on 6H-SiC(0001): Molecular Dynamics Simulation" JOURNAL OF APPLIED PHYSICS, vol. 103, 17 mars 2008 (2008-03-17), pages 063505-063509, XP002563350
- CAPPELLI E ET AL: "Critical role of laser wavelength on carbon films grown by PLD of graphite" APPLIED PHYSICS A; MATERIALS SCIENCE & PROCESSING, SPRINGER, BERLIN, DE, vol. 93, no. 3, 13 juin 2008 (2008-06-13), pages 751-758, XP019655820 ISSN: 1432-0630
- L. GOMEZ DE ARCO, Y. ZHANG, A. KUMAR, C. ZHOU: "Synthesis, Transfer, and Devices of Single- and Few-Layer Graphene by Chemical Vapor Deposition" RESEARCH LETTER, vol. 8, no. 2, 6 mars 2009 (2009-03-06), pages 135-138, XP002563355

## Description

### DOMAINE TECHNIQUE

La présente invention a trait à un procédé d'élaboration du graphène mettant, notamment, en oeuvre une étape de recuit sous irradiation.

Le graphène est un cristal monoplan se présentant sous forme d'un plan de carbone, où les atomes sont positionnés suivant un ordre régulier de structure hexagonale, l'épaisseur de ce plan correspondant à celle d'un atome de carbone correspondant ainsi à une épaisseur inférieure au nanomètre.

Du fait que le graphène se présente sous forme d'un réseau hexagonal plan, chaque atome de carbone se trouve ainsi lié à trois atomes de carbone, laissant ainsi un électron libre parmi les quatre électrons externes disponibles pour les liaisons chimiques. Ces électrons libres sont susceptibles ainsi de se déplacer le long du réseau cristallin.

Les expériences ont pu montrer que les propriétés électroniques du graphène ne sont ni celles d'un conducteur métallique ni celles d'un semiconducteur mais que les électrons se déplacent comme s'ils avaient perdu leur masse et ce, à une vitesse proche de celle de la vitesse de la lumière. Qui plus est, d'un point de vue mécanique, le graphène offre une rigidité mécanique exceptionnelle.

Ainsi, même si l'étude de ce matériau reste à approfondir, cela n'a pas empêché la communauté scientifique de s'intéresser aux applications potentielles du graphène, parmi lesquelles on peut citer :
*l'utilisation du graphène dans le domaine de la nanoélectronique. En effet, le graphène peut être utilisé pour former un constituant de base de l'électronique, tel qu'un transistor, car, outre sa taille nanométrique, il s'avère stable à température ambiante et ses électrons peuvent se propager en ligne droite sur de grandes distances par rapport à l'échelle atomique et à une vitesse élevée (transport balistique sur des distances micrométriques). Il pourrait ainsi constituer un candidat de choix au remplacement du silicium, en permettant d'accéder à des dispositifs plus petits et plus rapides que ceux obtenus avec le silicium ;
*l'utilisation du graphène dans le domaine de la détection de gaz. En effet, des chercheurs ont constaté que le déplacement des électrons à la surface du graphène, autrement dit sa conductivité, était affecté lorsque le graphène se trouvait en contact avec certaines molécules de gaz. Les expérimentations mises en oeuvre ont permis notamment de détecter une molécule de NO₂ sur un milliard, soit mille fois mieux que les meilleurs détecteurs actuels utilisant les nanotubes ;
*l'utilisation du graphène pour constituer d'autres matériaux carbonés tels que les nanotubes ou les fullerènes par enroulement de feuillets de graphène sur eux-mêmes ;
*l'utilisation du graphène pour réaliser des expériences de physique fondamentale, notamment à l'échelle nanométrique.

### ÉTAT DE LA TECHNIQUE ANTÉRIEURE

L'élaboration du graphène reste un des obstacles aujourd'hui à une utilisation à grande échelle de celui-ci pour les applications qui lui sont destinées. A l'heure actuelle, deux méthodes principales existent pour l'élaboration du graphène.

Une première méthode consiste à extraire mécaniquement une feuille unique de graphène à partir d'un cristal de graphite par clivage micromécanique. Ceci a été opéré notamment par une méthode de « peel-off » (ou pelage) en arrachant avec un simple scotch des morceaux de graphite et en les déposant ensuite sur un substrat isolant, tel qu'un substrat en dioxyde de silicium (SiO₂). L'opération est réitérée plusieurs fois. Parmi les dépôts de graphite sur le substrat, figurent de nombreux microcristaux de graphite formés le plus souvent de plusieurs dizaines ou centaines de couches de graphène. Seule une très faible fraction comporte des feuilles isolées de graphène. Cette méthode ne permet pas de produire une large surface de graphène nécessaire à une éventuelle utilisation dans une puce ou autres circuits.

Une deuxième méthode consiste à partir non pas d'un cristal de graphite mais d'un cristal de carbure de silicium (SiC). Ainsi, en chauffant du carbure de silicium (généralement élaboré par épitaxie) deux heures à 1400°C générant ainsi une évaporation du silicium, il subsiste uniquement des atomes de carbone à la surface du cristal, qui se lient spontanément en formant un réseau hexagonal et, formant de la sorte, une phase graphène/graphite.

Que ce soit pour la première méthode ou pour la seconde méthode, l'on n'obtient pas de grandes surfaces de graphène (généralement des plans de graphène de quelques mm² aléatoirement disposés sur l'échantillon) rendant ainsi sa localisation sur la surface, sa manipulation et son extraction difficiles. Pour pouvoir rendre la manipulation faisable, il peut être procédé à un report de couches sur d'autres supports que ceux qui ont servi de base à l'élaboration de graphène. Toutefois, ces étapes de report altèrent la qualité des couches de graphène.

Le document New Journal of Physics 11 (2009), p.023006-023027 décrit également la préparation de graphène, mais par décomposition catalytique d'hydrocarbures (en particulier, de l'éthylène) sur un substrat en métal de transition, qui joue le rôle de catalyseur.

### Deux méthodes sont décrites :

- une première méthode mettant en oeuvre une étape d'adsorption, à température ambiante, de molécules d'hydrocarbures sur un substrat tel que défini ci-dessus suivie d'une étape de pyrolyse et de croissance de graphène sur ledit substrat ; et
- une étape de croissance de graphène par dépôt en phase chimique (CVD) d'éthylène sur un substrat porté à haute température.

Le document Applied Surface Science, 252, n°13, 2006, p.4877-4881 décrit la préparation de films de carbone nanostructurés comprenant une étape de dépôt, dans une chambre sous vide, de films minces en carbone par ablation laser pulsée d'une cible en graphite pyrolitique sur un substrat en Si (100), cette étape de dépôt étant réalisée à différentes températures de substrat (de la température ambiante à 900°C) et sous différentes conditions atmosphériques, l'augmentation de la température du substrat pouvant être à l'origine de la formation de graphène.

Les inventeurs se sont proposé de mettre au point un nouveau procédé d'élaboration de graphène de mise en oeuvre simple et ne nécessitant pas notamment d'étape de report de couches de graphène sur d'autres supports que ceux qui ont servi à l'élaboration dudit graphène et, qui plus est, qui permette l'obtention de graphène sur une surface identique à celle du substrat qui sert de base à l'élaboration de graphène.

### EXPOSÉ DE L'INVENTION

Ainsi, l'invention a trait à un procédé d'élaboration de graphène comprenant respectivement les étapes suivantes :
- une étape de dépôt sur un substrat comprenant du silicium d'une couche comprenant du carbone amorphe;
- une étape de recuit de ladite couche sous irradiation photonique laser, moyennant quoi l'on obtient une couche comprenant du graphène.

Ainsi, les inventeurs ont découvert, de manière surprenante, qu'en associant une étape de réalisation d'une couche à base de carbone amorphe à une étape de recuit spécifique, il est possible d'obtenir facilement du graphène sur l'ensemble de la surface du substrat (ce qui permet d'obtenir des plans de graphènes de surface aussi étendue que celle du substrat sous-jacent) sans qu'il soit nécessaire ensuite de procéder au report du graphène sur d'autres substrats.

Qui plus est, ce procédé met en oeuvre des étapes, qui peuvent tout à fait être réalisées en milieu industriel, ce qui contribue à rendre ce procédé applicable à l'échelle industrielle.

Selon une première étape, le procédé de l'invention comprend une étape de dépôt sur un substrat comprenant du silicium d'une couche comprenant du carbone amorphe.

On entend, généralement, au sens de l'invention, par carbone amorphe une forme allotropique du carbone, éventuellement hydrogéné (auquel cas il est symbolisé par l'abréviation a :C-H) comprenant un mélange de sites à trois liaisons (carbone en état d'hybridation sp²) et à quatre liaisons (carbone en état d'hybridation sp³), sans qu'il y ait toutefois un modèle à longue portée des positions atomiques.

Le substrat peut être de dimensions variables, pouvant aller d'un simple coupon à un substrat présentant plusieurs centimètres de longueur (par exemple, un substrat présentant une longueur de 300 mm), les dimensions choisies étant celles que l'on souhaite obtenir pour le graphène.

Comme substrat comprenant du silicium, il peut s'agir d'un substrat en silicium cristallin, un substrat en polysilicium, un substrat en silicium amorphe, un substrat en silicium épitaxié, un substrat en dioxyde de silicium, un substrat en carbure de silicium SiC, un substrat en oxycarbure de silicium (intitulé SiOC), un substrat en nitrure de silicium, un substrat en carbonitrure de silicium (intitulé SiCN), un substrat comprenant du silicium, de l'oxygène, du carbone et du fluor (intitulé SiOCF), un substrat en boronitrure de silicium. Il peut s'agir également d'un substrat en arséniure de gallium (intitulé GaAs).

D'un point de la nature cristalline, il peut s'agir en particulier, d'un substrat à maille cristalline ayant une orientation spécifique (100), (110), (111) ou (222).

Avantageusement, le substrat utilisé dans le cadre du procédé de l'invention est un substrat en carbure de silicium, de préférence, épitaxié, présentant une orientation spécifique de type (111).

Cette étape de dépôt peut être réalisée par voie vapeur ou par voie humide à partir d'au moins un précurseur carboné.

Lorsqu'elle est réalisée par voie vapeur, il peut s'agir d'un dépôt physique en phase vapeur (intitulé également PVD pour « Physical Vapor Deposition »), d'un dépôt chimique en phase vapeur (intitulé également CVD pour « Chemical Vapor Deposition »), d'un dépôt par couches atomiques (intitulé également ALD pour « Atomic Layer Deposition »).

Lorqu'elle est réalisée par voie humide, il peut s'agir d'une étape mettant en oeuvre la technique d'évaporation par faisceau d'électrons, la technique d'enduction centrifuge (correspondant à la terminologie anglaise « spin-coating »).

En particulier, il peut s'agir d'un dépôt chimique en phase vapeur assisté par filament chaud (connu sous le sigle HFCVD pour « Hot Filament Chemical Vapor Deposition »), d'un dépôt chimique en phase vapeur assisté par UV, d'un dépôt chimique en phase vapeur cryogénique, d'un dépôt chimique en phase vapeur assisté par plasma (connu sous le sigle PECVD pour « Plasma Enhanced Chemical Vapor Deposition »).

De préférence, l'étape de dépôt de la couche comprenant du carbone amorphe est effectuée par dépôt chimique en phase vapeur assistée par plasma (PECVD). En particulier, dans ce cas de figure, le plasma peut être généré par ionisation d'un gaz par le biais d'une décharge électrique micro-ondes, radiofréquence ou basse-fréquence. De préférence, le plasma est généré par ionisation d'un gaz par le biais d'une décharge électrique radiofréquence, auquel cas on parlera de dépôt chimique en phase vapeur assisté par plasma radiofréquence. Un tel dépôt peut être réalisé dans un réacteur plasma de type capacitif avec une excitation radiofréquence de 13,56 MHz quel que soit la taille du substrat.

De façon générale, le dépôt chimique en phase vapeur assisté par plasma consiste en la formation sur un substrat d'un film par réaction chimique de précurseurs carbonés gazeux à la surface dudit substrat, ces précurseurs gazeux étant issus de précurseurs carbonés nécessaires à la formation de carboné amorphe.

Des précurseurs carbonés nécessaires à la formation de la couche comprenant du carbone amorphe peuvent être des précurseurs hydrocarbonés, linéaires ou cycliques. Il peut s'agir, notamment, d'alcanes, tels que du méthane (CH₄), du propane (C₃H₈) existant sous ses différents isomères, du butane (C₄H₁₀) existant sous ses différents isomères, des alcènes, tels que le propène (C₃H₆) existant sous ses différents isomères, le butène (C₄H₈) existant sous ses différents isomères, des alcynes tels que l'acétylène (C₂H₂), le propyne (C₃H₄), des composés diéniques tels que le butadiène, des composés aromatiques tels le benzène, le toluène et des mélanges de ceux-ci.

Outre la présence des précurseurs susmentionnés, l'étape de dépôt peut mettre en oeuvre des gaz vecteurs, en particulier, des gaz inertes, tels que Ar, He, Ne, Xe et les mélanges de ceux-ci, en particulier de l'hélium.

Les grandeurs régissant les caractéristiques du plasma peuvent être respectivement :
- la fréquence qui génère le plasma permettant de jouer sur le bombardement ionique du substrat, ce qui rend ainsi possible la modification de la densité de la couche, la structure et la vitesse de formation de celle-ci ;
- la puissance du plasma, étant à l'origine du taux de dissociation des espèces en phase gazeuse ;
- la pression dans l'enceinte, qui doit être fixée de sorte à favoriser les réactions en phase gazeuse.

D'autres grandeurs indépendantes du plasma peuvent également intervenir telles que la température du substrat sur lequel la couche est déposée ainsi que les débits de précurseur(s) et éventuellement de gaz vecteur(s).

Ainsi, selon le procédé de l'invention, les caractéristiques du plasma peuvent être les suivantes :
- une radiofréquence fixe allant de 13 à 14 MHz, telle qu'une radiofréquence de 13,56 MHz ;
- une puissance allant de 50 à 1000 W ;
- une pression allant de 1 à 20 torrs ;
- un espacement des électrodes allant de 300 à 600 mils.

Quant aux autres caractéristiques, elles peuvent être avantageusement les suivantes :
- une température du substrat allant de 100 à 1000°C ;
- un flux de précurseur carboné allant de 50 à 2000 sccm.

On précise que, par sccm, on entend un centimètre cube standard par minute, soit 1 cm³/min dans les conditions standards de température et de pression correspondant à une température de 0°C et à une pression de 101 325 Pa (soit 1 atm).

De tels paramètres permettent notamment de déposer une couche à raison de 100 à 1000 Å/cm.

L'homme du métier déterminera, en fonction des précurseurs carbonés et du substrat choisis, par de simples essais, les caractéristiques du plasma de sorte à obtenir une couche comprenant du carbone amorphe.

De préférence, la couche comprenant du carbone amorphe comprend plus de 50% de carbone en état d'hybridation sp².

Ce taux de carbone en état d'hybridation sp² peut être visualisé à l'aide de spectres XPS ou de spectres IR à transformée de Fourier.

Une fois l'étape de dépôt de la couche effectuée, il est procédé, selon l'invention, à une étape de recuit de la couche sous irradiation photonique laser, de sorte à obtenir la formation de graphène.

Cette étape de recuit peut être réalisée par un chauffage de la couche préalablement déposée (il s'entend d'un chauffage par une source externe à l'irradiation), tout en la soumettant parallèlement à une irradiation par des photons issus d'un laser.

Cette étape de recuit peut être réalisée également par le simple fait de soumettre la couche à l'irradiation susmentionnée, la chaleur nécessaire au recuit provenant ainsi de cette seule irradiation. Dans ce cas, il n'est pas nécessaire de procéder au chauffage par une source externe à l'irradiation. Dans ce cas, l'apport thermique nécessaire au recuit est apporté par l'interaction laser/film, en modulant la puissance du faisceau.

Lorsqu'un chauffage par une source externe autre que l'irradiation est nécessaire, celui-ci peut être effectué dans une enceinte chauffante ou par le biais d'un substrat chauffant, tel qu'un suscepteur, sur lequel est déposé le substrat recouvert par la couche comprenant du carbone amorphe.

Le recuit peut être effectué à une température qui peut aller de la température ambiante (par exemple 20°C) à 1200°C. La température de recuit peut être atteinte en appliquant une rampe de température allant de 0,1 à 100 °C/min pendant une durée pouvant aller de 1 minute à 12 heures.

Le recuit peut être réalisé sous haute pression (typiquement de 1 à 1000 torrs) ou sous ultravide (typiquement à une pression de 10⁻⁶ à 1 torr).

Le chauffage peut être effectué en atmosphère de gaz inerte, tel que N₂, des gaz rares comme He, Ar, Ne, Kr, Xe ou en atmosphère de gaz réducteur (par exemple, en présence d'hydrogène).

Selon l'invention, l'irradiation à laquelle est soumise la couche est une irradiation laser. Le laser utilisé peut être un laser Nd/YAG (c'est-à-dire un laser grenat d'yttrium-aluminium dopé au néodyme).

L'irradiation laser peut se matérialiser sous forme de pulsations laser à une fréquence pouvant aller de 1 Hz à 10 kHz pour une longueur d'ondes allant de 200 à 600 nm et une énergie allant de 0,1 à 100 J/cm² sur une durée s'étalant de 1 minute à 12 heures.

L'homme du métier déterminera, en fonction des précurseurs carbonés et du substrat choisis, par de simples essais, les caractéristiques du recuit en termes de chauffage et d'irradiation pour obtenir la couche comprenant du graphène.

L'invention va être à présent décrite en rapport à l'exemple suivant donné à titre illustratif et non limitatif.

### EXPOSÉ DÉTAILLÉ DE MODES DE RÉALISATION PARTICULIERS

### EXEMPLE DE REALISATION

Cet exemple de réalisation se déroule en deux parties :
- une première partie au cours de laquelle il est procédé au dépôt, sur une plaque de silicium, d'une couche de carbure de silicium, qui sert de base de dépôt au graphène ;
- une deuxième partie au cours de laquelle il est réalisé sur la couche de carbure de silicium une couche de graphène.

Ainsi, dans la première partie, une plaque de silicium de diamètre de 200 mm est placée dans une enceinte d'un réacteur LPCVD (à savoir, un réacteur apte à permettre un dépôt chimique en phase vapeur à basse pression) de sorte à permettre le dépôt par hétéroépitaxie sur celle-ci d'une couche de carbure de silicium.

Pour ce faire, il est procédé, dans un premier temps, à une désorption en oxygène du réacteur à 1200°C pendant 5 minutes avec 3 litres standards/minutes (SLM) de H₂. Puis, dans un deuxième temps, il est introduit dans le réacteur un mélange de SiH₄ (à un débit de 0,8 sccm), de C₂H₄ (à un débit de 0,5 sccm) et de 3 SLM de H₂ pendant 10 minutes à une température de 1100°C et à une pression de 200 torrs.

Dans de telles conditions, l'on obtient une couche de SiC d'épaisseur nominale d'environ 1 *µ*m présentant une morphologie de surface ordonnée (cubique ou hexagonale) et une orientation cristalline selon un plan (111).

Selon la deuxième partie, le substrat ainsi obtenu est placé dans un réacteur adapté à la technique PECVD de type capacitif radio-fréquence. Une couche mince de carbone amorphe a :C-H est déposée par PECVD avec un mélange gazeux Ar/CH₄. La couche mince est déposée sous une pression totale de 0,3 torr et le total des flux entrant de gaz est de 1000 sccm (90% de CH₄ et 10% d'Ar). Le substrat est chauffé à une température de l'ordre de 550°C. Cette condition permet l'obtention d'une couche comprenant du carbone amorphe à caractère graphitique (c'est-à-dire comprenant plus de 50% de carbone en état d'hybridation sp²) avec une épaisseur moyenne de 300 nm pour un dépôt d'une durée de 30 secondes.

La couche obtenue comporte, sur la totalité du carbone, 40% de carbone en état d'hybridation sp³ et 60% de carbone en état d'hybridation sp² et comporte 30 à 40% d'hydrogène. Elle présente également une densité allant de 1,6 à 2,2 g/cm³.

Cette proportion peut être déterminée par spectroscopie IR à transformée de Fourier en suivant les liaisons CH₂ sp² à 2970 cm⁻¹ et à 3025 cm⁻¹. Elle peut être déterminée également par spectroscopie XPS où on suit la raie du carbone 1s pour déterminer les niveaux d'hybridation. On calcule ensuite le rapport C sp²/(C sp² + C sp³). Le carbone en état d'hybridation sp² et le carbone en état d'hybridation sp³ apparaissent avec un décalage de 0,6 à 0,8 eV autour du pic principal à 285 eV.

Le plasma est généré par application d'une radiofréquence de 13,56 MHz avec une puissance de 300 W.

Le substrat recouvert de la couche comprenant du carbone amorphe est ensuite disposé dans une chambre maintenue sous vide par pompage turbomoléculaire (la pression dans la chambre étant de 5*10⁻⁶ Torr). Un rayonnement laser pulsé (plus précisément, un laser ablation Nd :YAG émettant à 532 nm avec une énergie de 2,33 eV à une fréquence de 10 Hz, les pulses ayant les caractéristiques suivantes : 7 ns pendant 15 minutes) est focalisé sur la couche avec un angle d'incidence de 45° avec un spot de 1 * 5mm. L'énergie radiative du laser est maintenue à 7 J/cm². L'exposition du laser sur la couche est accompagnée par un chauffage du porte-substrat, qui permet de maintenir la température de l'échantillon à 1100°C. Un balayage du spot laser sur la surface de l'échantillon est opéré en bandes pour recuire tout le matériau. Ce recuit est d'une durée de 6 heures.

Le spectre Raman laisse apparaître une bande à 2700 cm⁻¹ attestant de la présence de graphène.

## Revendications

1. Procédé d'élaboration de graphène comprenant respectivement les étapes suivantes :
- une étape de dépôt sur un substrat comprenant du silicium d'une couche comprenant du carbone amorphe ;
- une étape de recuit de ladite couche sous irradiation photonique laser, moyennant quoi l'on obtient une couche comprenant du graphène.

2. Procédé selon la revendication 1, dans lequel le substrat comprenant du silicium est un substrat en silicium cristallin, un substrat en polysilicium, un substrat en silicium amorphe, un substrat en silicium épitaxié, un substrat en dioxyde de silicium, un substrat en carbure de silicium, un substrat en oxycarbure de silicium, un substrat en nitrure de silicium, un substrat en carbonitrure de silicium (SiCN), un substrat comprenant du silicium, de l'oxygène, du carbone et du fluor (intitulé SiOCF) ou un substrat en boronitrure de silicium.

3. Procédé selon l'une quelconque des revendications précédentes, dans lequel le substrat est un substrat à maille cristalline ayant une orientation spécifique (100), (110), (111) ou (222).

4. Procédé selon l'une quelconque des revendications précédentes, dans lequel le substrat est un substrat en carbure de silicium, de préférence, épitaxié, présentant une orientation spécifique de type (111).

5. Procédé selon l'une quelconque des revendications précédentes, dans lequel l'étape de dépôt est réalisée par voie vapeur ou par voie humide à partir d'au moins un précurseur carboné.

6. Procédé selon la revendication 5, dans lequel, lorsque l'étape de dépôt est réalisée par voie vapeur, elle est effectuée par dépôt physique en phase vapeur (intitulé également PVD pour « Physical Vapor Deposition »), dépôt chimique en phase vapeur (intitulé également CVD pour « Chemical Vapor Deposition »).

7. Procédé selon la revendication 6, dans lequel, lorsque l'étape de dépôt est réalisée par dépôt chimique en phase vapeur, elle est effectuée par dépôt chimique en phase vapeur assisté par filament, dépôt chimique en phase vapeur assisté par UV, dépôt chimique en phase vapeur cryogénique, dépôt chimique en phase vapeur assisté par plasma.

8. Procédé selon la revendication 6 ou 7, dans lequel l'étape de dépôt est réalisée par dépôt chimique en phase vapeur assisté par plasma.

9. Procédé selon l'une quelconque des revendications 5 à 8, dans lequel le précurseur carboné est choisi parmi les alcanes, les alcènes, les alcynes, les composés diéniques, les composés aromatiques et les mélanges de ceux-ci.

10. Procédé selon l'une quelconque des revendications précédentes, dans lequel la couche comprenant du carbone amorphe comprend plus de 50% de carbone en état d'hybridation sp².

11. Procédé selon l'une quelconque des revendications précédentes, dans lequel l'étape de recuit est réalisée à une température allant de la température ambiante (par exemple 20°C) à 1200°C.

## Patentansprüche

1. Verfahren zur Herstellung von Graphen, das jeweils die nachfolgenden Schritte umfasst:
- einen Schritt der Aufbringung einer Schicht, die amorphen Kohlenstoff enthält, auf einem Substrat, das Silizium enthält;
- einen Schritt des Heizens der Schicht unter photonischer Laserbestrahlung, wodurch man eine Schicht erhält, die Graphen enthält.

2. Verfahren nach Anspruch 1, wobei das Substrat, das Silizium enthält, ein Substrat aus kristallinem Silizium ist, ein Substrat aus Polysilizium, ein Substrat aus amorphem Silizium, ein Substrat aus epitaktischem Silizium, ein Substrat aus Siliziumdioxid, ein Substrat aus Siliziumcarbid, ein Substrat aus Siliziumoxicarbid, ein Substrat aus Siliziumnitrid, ein Substrat aus Siliziumcarbonitrid (SiCN), ein Substrat, das Silizium, Sauerstoff, Kohlenstoff und Fluor enthält (als SiOCF bezeichnet), oder ein Substrat aus Siliziumboronitrid.

3. Verfahren nach einem der vorhergehenden Ansprüche, wobei das Substrat ein Substrat mit einem Kristallgitter ist, das eine spezifische Orientierung (100), (110), (111) oder (222) hat.

4. Verfahren nach einem der vorhergehenden Ansprüche, wobei das Substrat ein vorzugsweise epitaktisches Substrat aus Siliziumcarbid ist, das eine spezifische Orientierung vom Typ (111) aufweist.

5. Verfahren nach einem der vorhergehenden Ansprüche, wobei der Aufbringungsschritt auf dem Dampfweg oder auf dem Feuchtweg ausgehend von wenigstens einem kohlenstoffhaltigen Präkursor realisiert wird.

6. Verfahren nach Anspruch 5, wobei dann, wenn der Aufbringungsschritt auf dem Dampfweg realisiert wird, er durch physikalische Dampfphasenaufbringung ausgeführt wird (auch als PVD für "Physical Vapor Deposition" bezeichnet), oder chemische Dampfphasenaufbringung (auch als CVD für "Chemical Vapor Deposition" bezeichnet).

7. Verfahren nach Anspruch 6, wobei dann, wenn der Aufbringungsschritt durch chemische Dampfphasenaufbringung realisiert wird, er durch eine filamentunterstützte chemische Dampfphasenaufbringung ausgeführt wird durch eine UV-unterstützte chemische Dampfphasenaufbringung, eine kryogene chemische Dampfphasenaufbringung, eine plasmaunterstützte chemische Dampfphasenaufbringung.

8. Verfahren nach Anspruch 6 oder 7, wobei der Aufbringungsschritt durch eine plasmaunterstützte chemische Dampfphasenaufbringung realisiert wird.

9. Verfahren nach einem der Ansprüche 5 bis 8, wobei der kohlenstoffhaltige Präkursor ausgewählt ist aus den Alkanen, den Alkenen, den Alkinen, den Dienverbindungen, den aromatischen Verbindungen und deren Mischungen.

10. Verfahren nach einem der vorhergehenden Ansprüche, wobei die Schicht, die amorphen Kohlenstoff enthält, mehr als 50 % Kohlenstoff im Hybridisierungszustand sp² enthält.

11. Verfahren nach einem der vorhergehenden Ansprüche, wobei der Heizschritt bei einer Temperatur realisiert wird, die von Umgebungstemperatur (beispielsweise 20°C) bis 1200 °C geht.

## Claims

1. Method of production of graphene comprising the following stages respectively:
- a stage of deposition of a layer comprising amorphous carbon on a substrate comprising silicon;
- a stage of annealing of said layer under photonic laser irradiation, by which a layer comprising graphene is obtained.

2. Method according to Claim 1, in which the substrate comprising silicon is a substrate of crystalline silicon, a substrate of polysilicon, a substrate of amorphous silicon, a substrate of epitaxial silicon, a substrate of silicon dioxide, a substrate of silicon carbide, a substrate of silicon oxycarbide, a substrate of silicon nitride, a substrate of silicon carbonitride (SiCN), a substrate comprising silicon, oxygen, carbon and fluorine (designated SiOCF) or a substrate of silicon boronitride.

3. Method according to any one of the preceding claims, in which the substrate is a substrate with a unit cell having a specific orientation (100), (110), (111) or (222).

4. Method according to any one of the preceding claims, in which the substrate is a substrate of silicon carbide, preferably grown epitaxially, having a specific orientation of the (111) type.

5. Method according to any one of the preceding claims, in which the deposition stage is carried out by vapour deposition or by wet deposition from at least one carbon-containing precursor.

6. Method according to Claim 5, in which, when the deposition stage is carried out by vapour deposition, it is carried out by physical deposition in the vapour phase (also designated PVD for Physical Vapour Deposition), or chemical deposition in the vapour phase (also designated CVD for Chemical Vapour Deposition).

7. Method according to Claim 6, in which, when the stage of deposition is carried out by chemical vapour deposition, it is carried out by filament-assisted chemical vapour deposition, UV-assisted chemical vapour deposition, cryogenic chemical vapour deposition, or plasma-enhanced chemical vapour deposition.

8. Method according to Claim 6 or 7, in which the deposition stage is carried out by plasma-enhanced chemical vapour deposition.

9. Method according to any one of Claims 5 to 8, in which the carbon-containing precursor is selected from alkanes, alkenes, alkynes, diene compounds, aromatic compounds and mixtures thereof.

10. Method according to any one of the preceding claims, in which the layer comprising amorphous carbon comprises more than 50% of carbon in the sp² hybridization state.

11. Method according to any one of the preceding claims, in which the stage of annealing is carried out at a temperature in the range from room temperature (for example 20°C) to 1200°C.
